# EUROPEAN PATENT APPLICATION

(11) **EP 2 216 791 A1**
(43) Date of publication of application: **11.08.2010**
(21) Application number: 08855605.5
(22) Date of filing: 27.11.2008
(51) Int. Cl.: H01B 5/14, C23C 14/08, C23C 16/30, H01B 13/00, H01L 31/04

(54) **TRANSPARENT ELECTROCONDUCTIVE FILM AND PROCESS FOR PRODUCING THE TRANSPARENT ELECTROCONDUCTIVE FILM**

(30) Priority: 30.11.2007 JP 2007310486; 25.03.2008 JP 2008078785
(71) Applicant: Kaneka Corporation, Kita-ku Osaka-shi, Osaka 530-8288 (JP)
(72) Inventor: KUCHIYAMA, Takashi, Settsu-shi Osaka 566-0072 (JP); YAMAMOTO, Kenji, Settsu-shi Osaka 566-0072 (JP); ICHIKAWA, Mitsuru, Settsu-shi Osaka 566-0072 (JP); KONDO, Kozo, Settsu-shi Osaka 566-0072 (JP)
(74) Representative: Vossius & Partner
(86) International application number: PCT/JP2008/071537
(87) International publication number: WO 2009/069695

(57) **Abstract**

A transparent electroconductive film includes a transparent substrate, at least one transparent electroconductive oxide layer deposited on the transparent substrate, and a plurality of hydrogen-containing carbon layers deposited on the transparent electroconductive oxide layer. At least one of the transparent electroconductive oxide layers contains zinc oxide. The hydrogen-containing carbon layers may be more than one, in which at least one of the hydrogen-containing carbon layers has a refractive index of 1.25 to 1.85. More preferably, the transparent electroconductive film satisfies a relationship of T₁/T₀ ≧ 1.02 for light having a wavelength of 550 nm where T₀ represents a light transmittance of the transparent substrate on which the at least one transparent electroconductive oxide layer is deposited and T₁ represents a light transmittance of the transparent substrate on which the at least one transparent electroconductive oxide layer and the plurality of hydrogen-containing carbon layers are deposited.

## Description

### TECHNICAL FIELD

The present invention relates to a transparent electroconductive film having improved light transmittance without lowering electrical conductivity mainly used in fields of a counter electrode material and a protection film of a touch panel, a material of a plasma display panel (PDP), a liquid crystal display (LCD), and an electroluminescence (EL) display, a transparent electrode and a back electrode of a solar cell, a transparent interlayer of a hybrid solar cell, a low-dielectric-constant film used for a high-speed electron compound semiconductor device, a surface acoustic wave element, a window glass coating for infrared cutoff, a gas sensor, application of nonlinear optics to a prism sheet, a transparent magnetic body, an optical recording element, an optical switch, an optical waveguide, an optical splitter, and an optoacoustic material, and a high-temperature heating material.

### BACKGROUND ART

In a transparent electroconductive film used for a touch panel, a display, a solar cell, and the like, a transparent electroconductive oxide (TCO) such as indium tin oxide (ITO), tin oxide, and zinc oxide is widely used as a transparent electroconductive oxide layer contained in the film. It is known that such a transparent electroconductive oxide layer is formed not only by a physical vapor deposition method (PVD method) such as a magnetron sputtering method and a molecular beam epitaxy method and/or a chemical vapor deposition method (CVD method) such as a thermochemical vapor deposition method and a plasma-enhanced chemical vapor deposition method but also by an electroless method.

ITO is excellent among TCOs as a transparent electroconductive material and recently widely used in a transparent electroconductive oxide layer. However, because of a possibility of depletion of raw material indium, search for materials alternative to indium has called for urgent attention in both resources and cost. Further, a technology to improve transparency of a transparent electroconductive film than ever before has been desires in accordance with a request of improved performance of products utilizing the films.

Zinc oxide (ZnO) can be advanced as an example of transparent electroconductive materials alternative to ITO. A nonpatent document 1 specified below describes that ZnO is more excellently transparent but is less stable to humidity and heat than ITO.

And now, a transparent electroconductive film used for a touch panel, for example, resistance to impact is needed in most cases judging from the nature of the intended purpose. Patent documents 1 to 3 specified below describe that resistance to impact is increased by formation of a covering layer on a transparent electroconductive oxide layer. However, the covering layer such as a nitride covering layer and an oxide covering layer as described in those patent documents may have rich stability to humidity and heat but may still have a problem of electrical conductivity. While, a carbon film described in the patent documents 1 to 3 may be ineffective in improving stability to humidity and heat though some carbon materials have rich electrical conductivity.

Lamination of the above-mentioned transparent electroconductive oxide material and a low refractive index material provides one of solutions to improve light transmittance from an optical aspect relating to transparency. However, the low refractive index material having an excessively-large absolute value of average dispersion might generate wavelength selectivity of reflection and transmission in the material in transmission of light, resulting in a possibility that transmitting light is seen as colored. For example, positively-large average dispersion causes light having a high wavelength to be easily reflected and to be seen as taken on a blue tinge. In contrast, negatively-large average dispersion causes light having a low wavelength to be easily reflected and to be seen to take on a red tinge.

That is why it is necessarily to select a material having small average dispersion so as to equally transmit all the light.
Patent Document 1: JP 2001-283643 A
Patent Document 2: JP 2003-34860 A
Patent Document 3: JP 2003-109434 A
Nonpatent Document 1: "Tomeidodenmaku" ("Transparent Electroconductive Film") edited by Mr, Yutaka Sawada, p.17, 2005, issued by CMC Publishing, Inc.
Nonpatent Document 2: "DLC Maku Handbook" ("DLC Film Handbook") edited by Mr. Hidetoshi Saito, p.495ff, 2006, issued by N,T.S. Inc.

### DISCLOSURE OF INVENTION

### TECHNICAL PROBLEM

As described above, transparency, resistance to impact, stability to humidity and heart, and electrical conductivity may be included in important factors for a transparent electroconductive film used for a touch panel, for example. Yet, a more excellent transparent electroconductive film than an ITO film, which is now a mainstream of the film, has not been put to practical use.

The present invention therefore aims to provide an improved transparent electroconductive film giving simultaneously a high resistance to environmental variation and a high light transmittance and a method for producing the same.

### SOLUTION TO PROBLEM

The present invention provides a transparent electroconductive film having the following configuration.

1). A method for producing a transparent electroconductive film including the steps of providing at least one transparent electroconductive oxide layer and depositing a carbon layer on at least one surface of the at least one transparent electroconductive oxide layer, wherein the carbon layer is formed by a high frequency plasma CVD method using at least one gas selected from a group consisting of methane, carbon dioxide, and hydrogen and satisfies at least one of below-identified expressions (1) to (3) relating to gas volumes V (methane), V(carbon dioxide), and V (hydrogen).
(1) 0.7 ≦ V (methane)/(V(methane) + V (hydrogen)) ≦ 1.0
(2) 0.6 ≦ V (methane)/(V (methane) + V (carbon dioxide)) ≦ 1.0
(3) 0.04 ≦ V (carbon dioxide)/(V (hydrogen) + V (carbon dioxide)) ≦ 0.10

2). A method for producing a transparent electroconductive film including the steps of providing at least one transparent electroconductive oxide layer and depositing a carbon layer on at least one surface of the at least one transparent electroconductive oxide layer, wherein the carbon layer is formed by a magnetron sputtering method targeting carbon and using at least two gases selected from a group consisting of carbon dioxide, hydrogen, and argon and satisfies at least one of below-identified expressions (4) and (5) relating to gas volumes V (carbon dioxide), V(hydrogen), and V (argon).
(4) 0.10 ≦ V (carbon dioxide)/(V (carbon dioxide) + V (hydrogen)) ≦ 0.30
(5) 0.10 ≦ V (carbon dioxide)/(V (carbon dioxide) + V (argon)) ≦ 0.30

3). A transparent electroconductive film prepared by the method as described in 1) or 2), wherein the carbon layer has a refractive index within a range of 1.25 to 1.85 at a wavelength of 550 nm and further has a value of a below-identified expression (6) within a range of 0.01 to 0.20, where n_{F} and n_{C} represent refractive indexes at wavelengths of 486.1 nm and 656.3 nm respectively.

(6) [average dispersion] = n_{F} - n_{C}
4). The transparent electroconductive film as described in 3), wherein the carbon layer has a density of 0.3 to 1.3 g/cm³.

5). The transparent electroconductive film as described in 3) or 4), wherein the carbon layer has a hydrogen content at 36.0 atom % or below in its structure.

6). The transparent electroconductive film as describe in one of 3) to 5), wherein the carbon layer has an SP³ bonding ratio at 55 % or more, the ratio being measured by X-ray photoelectron spectroscopy.

7). A transparent electroconductive film including a transparent substrate, at least one transparent electroconductive oxide layer deposited on the transparent substrate, and a plurality of hydrogen-containing carbon layers deposited on the transparent electroconductive oxide layer, wherein at least one layer of the transparent electroconductive oxide layer contains zinc oxide, and wherein at least two layers or the hydrogen-containing carbon layers are different from each other in at least one of their configurations and their compositions, the transparent electroconductive film satisfying a relationship of T₁/T₀ ≧ 1.02 for light having a wavelength of 550 nm where To represents a light transmittance of the transparent substrate on which the at least one transparent electroconductive oxide layer is deposited and T₁ represents a light transmittance of the transparent substrate on which the at least one transparent electroconductive oxide layer and the plurality of hydrogen-containing carbon layers are deposited.

8). The transparent electroconductive film as described in 7), wherein at least one of the plurality of hydrogen-containing carbon layers has a refractive index within a range of 1.40 to 1.70 for light having a wavelength of 550 nm. 9). The transparent electroconductive film as described in one of 1), 2) and 7), further including a transparent electroconductive oxide layer having a thickness of 20 nm and containing zinc oxide, the layer being deposited on one of the hydrogen-containing carbon layers.

10). A method for producing the transparent electroconductive film as described in one of 7) to 9), wherein each of the hydrogen-containing carbon layers is formed by a high frequency plasma CVD method using one of methane gas and a gas mixture of methane and hydrogen as a material gas.

### ADVANTAGEOUS EFFECT OF INVENTION

The present invention as described above can provide an improved transparent electroconductive film being favorable in transparency and resistance to environmental variation, which are important characteristics especially for a device such as a touch panel, an EL display, and a solar cell.

### BRIEF DESCRIPTION OF DRAWINGS

Fig. 1 is a schematic sectional view illustrating a laminated structure of a transparent electroconductive film of an embodiment of the present invention;
Fig. 2 is a schematic sectional view illustrating a laminated structure of a transparent electroconductive film relating to an example 5 of the present invention;
Fig. 3 is a schematic sectional view illustrating a laminated structure of a transparent electroconductive film relating an example 6 of the present invention;
Fig. 4 is a schematic sectional view illustrating a laminated structure of a transparent electroconductive film relating to an example 9 of the present invention; and
Fig. 5 is a schematic sectional view illustrating a laminate structure of a transparent electroconductive film relating to an example 12 of the present invention.

### BRIEF DESCRIPTION OF NUMERALS

- 1.: transparent substrate
- 2.: transparent electroconductive oxide layer
- 3.: hydrogen-containing carbon layer
- 4.: hydrogen-containing carbon layer
- 5.: additional transparent electrode layer

### BEST MODE FOR CARRYING OUT THE INVENTION

Conventionally, carbon films typified by a diamond-like carbon film have been used as coatings for reducing friction or surfaces. It has been recently expected to apply a carbon film to a low-dielectric-constant film or the like used in a device such as a solar cell and a high-speed electron compound semiconductor device. (Nonpatent Document 2) In the patent documents 1 to 3, transparent electroconductive films each containing a carbon film as a covering layer are disclosed.

Such carbon layers are normally formed by sputtering a carbon target using argon gas, so that the carbon films to be deposited are amorphous carbon films containing no hydrogen. Such a method for producing a carbon film enables to form a hard film, which undesirably might not ensure a stable protective effect against humidity and heat. The present inventors found that the use of a carbon layer containing hydrogen in its structure (hereinafter referred to as a hydrogen-containing carbon layer) as a covering layer allows a transparent electroconductive oxide layer containing zinc oxide to be stable in property against humidity and heat.

Additionally, such the carbon film formed by sputtering as described above has a composition with a graphite structure, resulting in difficulty in producing a carbon film being transparent at least within a visual light range. The present inventors found that the alteration of a depositing condition of a hydrogen-containing carbon layer readily increases light transmittance of a transparent electroconductive oxide layer covered with the hydrogen-containing carbon layer.

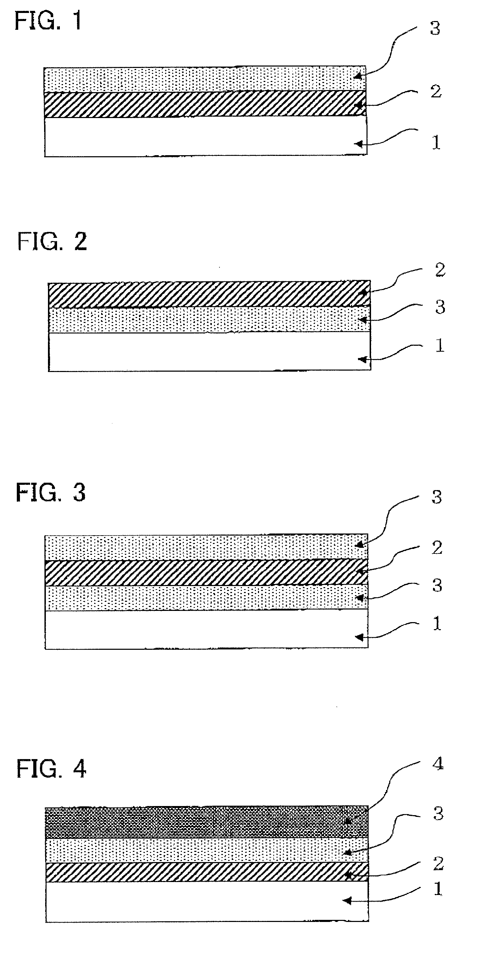

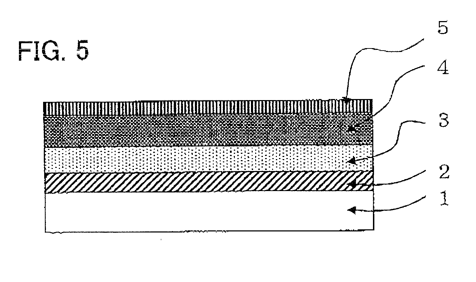

Now, major embodiments of a transparent electroconductive film relating to the present invention will be described in detail below
Figs. 1 to 5 each are a schematic sectional view illustrating a transparent electroconductive film relating to the present invention. A carbon layer 3 is deposited on either one surface (Figs. 1 and 2) or both surfaces (Fig. 3) of a transparent electroconductive oxide layer 2. In Figs. 4 and 5, two carbon layers 3 and 4 are deposited on the layer 2. In Fig. 5, there is further provided an additional transparent electrode layer 5.

A transparent substrate 1 is good enough only it is transparent at least within a visual light range and may be made of any material of either a hard material or a soft material. A hard material is typified by a glass substrate such as alkali glass, borosilicate glass, and alkali-free glass and may also be a material such as a sapphire substrate. A glass substrate to be used may have a thickness selected in discretion for purpose of use, but preferably has a thickness within a range of 0.5 mm to 4.5 mm in view of balance of handleablity and weight.

Too thin a glass substrate might be insufficient in strength, thereby being breakable by impact. In contrast, too thick a glass substrate is undesirable because of increased weight and further undesirable in view of difficulty in application to portable devices because the substrate affects a thickness of a device to which a transparent electroconductive film is applied. Further, a thick glass substrate is undesirable in view of transparency and cost phase.

A soft material is typified by a film consisting of a thermoplastic resin such as acrylic, polyester, polycarbonate, and polyolefin resin or thermosetting resin such as polyurethane, but preferably employs a film consisting of polyolefin resin that has especially low moisture permeability, which improves barrier properties against humidity by formation of a carbon film layer on a substrate with greater potential effect in stabilization of surface resistance expected from the properties. Above all, it is preferable to employ a film composed mostly of polycycloolefin that has excellent optical isotropy and excellent water vapor barrier properties. A polycycloolefin film is formed as a polymer such as a norbornene polymer, a norbornene-olefin copolymer, and an unsaturated fat cyclic hydrocarbon polymer such as cyclopentadiene.

In view of water vapor barrier properties, preferably a main chain and a side chain of a film constituent molecule do not contain functional group with a high polarity; such as carbonyl group or hydroxyl group. Such a soft material may also have a thickness selected in discretion for purpose of use, but is easy to handle with a thickness in the order of 0.03 mm to 3.0 mm. Too thin a film is undesirable because of being difficult to handle and insufficient in strength. In contrast, too thick a film is undesirable in view of transparency and cost phase. Further, it is undesirable in view of difficulty in application to portable devices because the substrate affects a thickness of a device to which a transparent electroconductive film is applied.

When a film is used as the substrate 1, a substrate film has a retardation value by being stretched. With a retardation value, the substrate film is combined with a polarization plate, thereby producing a low-reflection panel, so that a greater level of visibility of pictures is expected.

A retardation value can be given to a substrate film by the known method. The film can be subjected to a stretching treatment such as uniaxial stretching and biaxial stretching or an orientation treatment, for example. At this time, maintaining of the film at almost a glass-transition temperature encourages orientation of polymer backbone. The retardation value is preferably within a range, which depends on a function of the transparent electroconductive film to be purposed, of 50 to 300 nm for an anti-reflection effect and more preferably at about 137 nm, which is a quarter of a wavelength at about 550 nm for light most strongly recognized by human being.

The transparent electroconductive oxide layer 2 in this invention consists mainly of zinc oxide in all of TCOs in view of high transparency and low incidence or reduction reaction with hydrogen plasma existing in deposition of a hydrogen-containing carbon layer. A doping substance can be added to the transparent electroconductive oxide layer 2 for resistivity control and/or stabilization. The doping substance includes, for example, a compound containing an element such as aluminum, gallium, indium, tin, and boron and a compound containing phosphorus and nitrogen.

Deposition of the transparent electroconductive oxide layer 2 may be performed by various methods as long as a uniform thin film is formed. The method includes, for example, a vapor-phase deposition method such as a PVD method like sputtering and vapor deposition and various CVD methods, and further a method of forming a transparent electroconductive oxide layer by heating treatment after application of a solution containing an ingredient of a transparent electroconductive oxide layer by means such as spin coating, roll coating, spray coating, and dipping coating. Yet, in view of easier formation of a thin film having a thickness in nanometers, a vapor-phase deposition method is preferable.

In a case of formation of the transparent electroconductive oxide layer 2 by a vapor-phase deposition method, the substrate is preferably at a temperature, which depends on a softening temperature of the substrate, within a range of room temperature to 500 degrees centigrade and more preferably within a range of room temperature to 300 degrees centigrade. Further, it is preferable to be at a temperature within a range of room temperature to glass-transition temperature of the substrate and more preferably at a temperature of 30 degrees centigrade below the glass-transition temperature. Too low a temperature of the substrate impairs crystallinity of the transparent electroconductive oxide layer, thereby failing to ensure desired transparency and electrical conductivity. In contrast, too high a temperature of the substrate might result in thermal oxidation of a zinc oxide transparent electroconductive oxide layer or changes or disappearance of the retardation value of the film substrate.

Plasma discharge can be utilized for a vapor-phase deposition of the transparent electroconductive oxide layer 2. Power for plasma production is not particularly limited, but preferably within a range of 0.1 to 15 W/cm² and more preferably within a range of 1 to 13 W/cm² in view of productivity of crystallinity of a transparent electroconductive oxide layer. Too small an electric power might fail to deposit a transparent electrode layer. In contrast, too large a supplied electric power might cause damage to the substrate or damage to a deposition system by plasma. A carrier gas used for deposition of the transparent electroconductive oxide layer can consist of gas used for a general vapor-deposition method, and for example, can consist of gas such as argon, hydrogen, oxygen, and nitrogen.

The above-mentioned transparent electroconductive oxide layer 1 preferably has a film thickness of 50 to 5000 Å. Too thin a film thickness of the transparent electroconductive oxide layer might have extremely low electrical conductivity of the layer, resulting in failing to providing an effective transparent electroconductive film. In contrast, too thick a film thickness of the layer might provide poor transparency and further increase production costs. The carbon layer 3 is formed by a compound mainly consisting of carbon atom. It is possible to improve electrical conductivity by doping an element such as nitrogen, phosphorus, and boron, but sufficient electrical conductivity is expected without doping.

The carbon layer 3 required for the present invention is formed by a high frequency plasma CVD method. A material gas used in the method consists of at least one gas selected from methane, carbon dioxide, and hydrogen. Control of volume ratio of those gases controls properties of a carbon film. In order to have properties that is important for the present invention, control of the material gases within a range of below-identified expressions (1) to (3) forms an effective carbon layer for the present invention, where gas volumes are designated as V (methane), V (carbon dioxide), and V (hydrogen):
(1) 0.7 ≦ V (methane)/(V (methane) + V (hydrogen)) ≦ 1.0
(2) 0.6 ≦ V (methane)/(V (methane) + V (carbon dioxide)) ≦ 1.0
(3) 0.04 ≦ V (carbon dioxide)/(V (hydrogen) + V (carbon dioxide)) ≦ 0.10

A mass flow controlled disposed in the depositing system provides high accuracy control of the volume ratio. These gas volume ratios mainly affect a water contact angle. In a case where the ratios are out of the above-identified range, a water contact angle required for the present invention is not obtained, which leads to low durability under high temperature and humidity environment. Further, increased hydrogen content might readily deposit carbon atom in high density due to a reaction of generated hydrogen atom and methane or carbon dioxide, resulting in formation of a carbon layer having a high refractive index. That might fail to lead to improvement of light transmittance as provided in the present invention.

Eclectic power is preferably within a range of 0.05 to 15 W/cm² and more preferably within a range of 0.1 to 13 W/cm². Too low a power might seriously affect productivity due to slow deposition. In contrast, too high a power is undesirable because the transparent electroconductive oxide layer might be etched by ionized gas. A power source includes a DC power source and a high-frequency power source and may employ any power source, but a high-frequency power source is more preferable in view of productivity due to a higher depositing rate. The carbon layer 3 in the present invention can be formed also by a magnetron sputtering method.

In a case of formation of the carbon layer 3 by a magnetron spluttering method, commonly-used carbon can be used as a target material. Carrier gases used in the method consist of at least two gases selected from carbon dioxide, hydrogen, and argon. Control of the carrier gases within a range of below-identified expressions (4) and (5) forms a carbon layer required for the present invention, where gas volumes are designated as V (carbon dioxide), V (hydrogen), and V (argon),:
(4) 0.10 ≦ V (carbon dioxide)/(V (carbon dioxide) + V (hydrogen))
   ≦ 0.30
(5) 0.10 ≦ V (carbon dioxide)/(V (carbon dioxide) + V (argon)) ≦ 0.30

Amass flow controller disposed in the depositing system provides high accuracy control of the volume ratio. These gas volume ratios mainly affect a water contact angle. In a case where the ratios are out of the above-identified range, a water contact angle required for the present invention is not obtained, which leads to low durability under high temperature and humidity environment. Further, increased hydrogen content might readily deposit carbon atom in high density due to a reaction of generated hydrogen atom and methane or carbon dioxide, resulting in formation of a carbon layer having a high refractive index. That might fail to lead to improvement of light transmittance as provided in the present invention. Still, increased argon content might form a graphite-reinforced carbon layer, which makes the carbon layer darker in color, resulting in being unsuitable for a transparent electroconductive film.

Electric power is preferably within a range of 0.05 to 15 W/em² and more preferably within a range of 0.1 to 13 W/cm². Too low a power might seriously affect productivity due to slow deposition. In contrast, too high a power is undesirable because the transparent electroconductive oxide layer might be etched by ionized gas. A power source includes a DC power source and a high-frequency power source and may employ any power source, but a high-frequency power source is more preferable in view of productivity due to a higher depositing rate and a smaller influence by carbonaceous insulating material deposited near the target.

The carbon layer 3 can be set in a discretionary film thickness depending on a film thickness of the transparent electroconductive oxide layer 2 or the refractive index of the carbon layer 3. For example, one-dimensional optical calculation provides approximate optimum values of the refractive index and the film thickness of the carbon layer 3 (Nonpatent Document 3).
Nonpatent Document 3: J. Krc et al., Progress in Photovoltaics 11 (2003) 15.
The carbon layer 3 preferably has the refractive index within a range of 1.25 to 1.85, Especially, it is more preferable to be controlled within a range of 1.25 to 1.70. It is most preferably to be within a range of 1.30 to 1.70.

The refractive index is measured by a single-wavelength or a spectroscopic ellipsometer readily and accurately. It is found that the control of mixing ratio of carbon dioxide and hydrogen as described above and the selection of power system between DC power system and RF power system enable to widely control a refractive index. A carbon layer having the refractive index smaller than 1. 25 becomes an organic compound or a high-molecular compound, not showing electrical conductivity, thus being unable to be used as a transparent electroconductive film.

Further, such a material is easy to form a porous structure, resulting in a potential problem of physical strength. In contrast, a carbon layer having the refractive index larger than 1.85 cannot expect an anti-reflection effect because the refractive index normally equals or surpasses that of a transparent electroconductive oxide layer.

Now, the wavelength dispersion of the refractive index will be described below. Nonpatent document 4 describes that the wavelength dispersion of the refractive index shows the refractive index variation depending on a wavelength and is a property inherent in a material. The wavelength dispersion is generally defined as amounts of average dispersion, relative dispersion, and specific dispersion. In the present invention, it is an important technology to be able to control average dispersion within a range of 0.01 to 0.20. The average dispersion is expressed in the below-identified expression (6).

(6) [average dispersion] = n_{F} - nc
Herein, n_{F} and n_{C} represent the refractive indexes of F- and C- spectral lines respectively, where F- and C- spectral lines are the wavelengths of 486.1 nm (H_{β}) and 656.3 nm (H_{α}) of hydrogen respectively. The larger the value of the expression (6) is, the larger the wavelength dispersion is, while the smaller the expression (6) is, the smaller the wavelength dispersion is. Generally, the value of the expression (6) being positive is referred to as a positive wavelength dispersion, while the value of the expression (6) being negative is referred to as a negative wavelength dispersion.

In the present invention, the value of the wavelength dispersion is preferably within a range of 0.01 to 0.20. For a transparent electrode material, this range of the wavelength dispersion facilitates transmission of light incoming from the carbon layer side without reflection loss in all wavelengths.

This property is important for a transparent electrode used in materials of a touch panel or a display in view of color compensation of graphics. The use of this material in a transparent electrode for a solar cell generates total reflection between a carbon layer and a photoelectric conversion layer (usually having a refractive index of three or more) due to the refractive index difference therebetween, which facilitates effective confinement of light. When being used in a middle layer of a solar cell, the film provides optimum characteristics due to selective reflection and transmission of light with the wavelength dispersion. When being used in a transparent electroconductive middle layer of a multi-unit organic EL, the film extracts light without reflection loss with the refractive index difference between the middle layer and an organic emitting layer.

Too large the positive wavelength dispersion is undesirable due to prominent optical selectivity, whereby transmitted light is seen as colored. Additionally, that is undesirable for a display material because light from yellow to red is strongly reflected. In contrast, too small the wavelength dispersion or the negative wavelength dispersion is undesirable for a solar cell due to prominent wavelength selectivity.

The wavelength dispersion of the refractive index is accurately measured by a spectroscopic ellipsometer.
Nonpatent Document 4: "Kagakubinran-kisohen (Handbook of chemistry-basic edition) (revised version 5)" edited by Chemical Society of Japan, II-p.557 (2004)
The carbon layer 3 preferably has a density within a range of 0.3 to 1.3 g/cm³. Having a density larger than this, the carbon layer 3 might be inclined to have a too large refractive index, which cannot be very effective in improvement of light transmittance that is important for the present invention. In contrast, too low a density is undesirable because the layer might be inclined to form a porous structure, which lowers physical durability and easily causes damage and deterioration.

The carbon layer 3 preferably contains hydrogen in its structure. The hydrogen content is preferably at 36.0 atom % or below, whereby the carbon layer desirable for the present invention is formed. Too much the hydrogen content is undesirable because of not only reduced scratch hardness that leads to a weakness to physical impact but also reduced electrical conductivity that leads to exhibition of electric characteristic similar to an insulation compound. The hydrogen content in the carbon layer is accurately measured by the hydrogen forward scattering spectrometry (HFS) method by the Rutherford backscattering spectrometry (RBS) device. Additionally, a film density is also measured by the Rutherford backscattering spectrometry.

The carbon layer 3 preferably has a SP³ bonding ratio in a carbon bonding, which is measured by an X-ray photoelectron spectroscopic spectral analysis, at 55 % or more, and more preferably within a range of 55 to 90 %. Too small the SP³ ratio might lower light transmittance because the layer 3 is approximated to a graphite structure. Alternatively, more SP² bonding ratio might lower durability due to a high water absorbability. Further, too much the SP³ bonding ratio might fail to serve as a transparent electroconductive film due to low electrical conductivity.

A surface resistance of the transparent electroconductive film was measured by a four-probe measurement specified by JIS K7194. The surface resistance, which depends on characteristics required in items to be used, is preferably within a range of 5 to 2000 Ω/Sq, The surface resistance larger than this range might fail to stabilize the surface resistance of the transparent electroconductive film, especially increasing the surface resistance shortly when left under a high temperature and humidity environment. In contrast, the surface resistance smaller than this range might thicken a film thickness of a transparent electroconductive oxide layer, rendering the transparent electroconductive oxide layer easily breakable due to stress and causing lowered transmittance and a cost problem.

The total light transmittance was measured by the integrating sphere light transmittance measurement device specified in JIS K7105.

The refractive index and the film thickness were measured by the spectroscopy ellipsometer.

The SP³ bonding ratio in the structure was measured by data analysis of bonding energy obtained by the X-ray photoelectron spectroscopy (XPS) measurement.

The density of the carbon layer and the hydrogen content in the layer were measured by the Rutherford backscattering spectrometry method/ the recoil scattering method.

Now, specific measurement devices will be described in detail below. The refractive index and the average dispersion assessments were determined by fitting the ellipsometric Δ (delta) and ψ (psi) with a Cauchy model. The ellipsometry measurements were performer by a spectroscopic ellipsometer VASE made by J. A. Woollam Co., Inc. The hydrogen content and the density were measured by the Rutherford backscattering method. The Rutherford backscattering method was performed by a vertically-mounted high-resolution RBS device HRBS 500 (made by Kobe Steel, Lid.).

The SP³ bonding ratio in the structure was measured by data analysis of bonding energy obtained by the X-ray photoelectron spectroscopy (XPS) device S-Probe ESCA Model 2803 (made by Surface Science Instruments). The surface resistance measurement was performed by a low resistivity meter LORESTA-GP (MCP-T610) (made by Mitsubishi Chemical Corp.). The light transmittance measurement was performed by a spectral photometer U-4100 (made by Hitachi High Technologies Corp.).

Fig. 4 is a schematic sectional view illustrating a transparent electroconductive film relating to an embodiment of the present invention. In this figure, a transparent electroconductive oxide layer 2 containing zinc oxide is deposited on a transparent substrate 1 having a thickness of 0.05 to 1.5 mm. A first hydrogen-containing carbon layer 3 and a second hydrogen-containing carbon layer 4 are deposited either on the surface of the transparent electroconductive oxide layer 2 or between the substrate 1 and the layer 2. The first hydrogen-containing carbon layer 3 and the second hydrogen-containing carbon layer 4 are different from each other in their structures and/or compositions.

It is possible to change the lamination order of the carbon layer 3 and the carbon layer 4 and also possible to sequentially laminate more than two layers. Further, another carbon layer can be sandwiches between the carbon layer 3 and the carbon layer 4. Further, the transparent electroconductive oxide layer 2 is not necessarily a single layer and obviously can be replaced by a plurality of TCO layers as long as the layers include at least one zinc oxide layer.

The hydrogen-containing carbon layers 3 and 4 are deposited for the put-pose of protection of a zinc oxide transparent electroconductive oxide layer against air and humidity and for the purpose of improvements of durability to physical impact and light transmittance in the transparent electroconductive oxide layer. Such the hydrogen-containing carbon layers preferably consist of hydrocarbon containing hydrogen in its structure and more preferably a diamond-like carbon, an amorphous hydrocarbon, or a tetrahedral amorphous hydrocarbon in view of physical strength and transparency.

In a case where the carbon layer 3 consists of a hydrogen-containing carbon layer, at least one layer of the hydrogen-containing carbon layers 3 and 4 preferably has a refractive index within a range of 1.4 to 1.7 for light having a wavelength of 550 nm. The hydrogen-containing carbon layer having such the refractive index covers a film, thereby improving a light transmittance of the transparent electroconductive film.

A normal carbon layer is generally formed by technologies such as the known CVD method, sputtering method, ion plating method and vapor-deposition method, but the hydrogen-containing carbon layer in the present invention is formed only by the high frequency plasma CVD method. The high-frequency power source used in the high-frequency plasma CVD method has a frequency band such as RF, VHF, and micro wave, but any of the high-frequency power sources can be used so as to obtain the desired hydrogen-containing carbon layer.

The material gas may consist of a common gas containing carbon and hydrogen and may use methane gas or methane gas diluted with hydrogen depending on a structure of a desired hydrogen-containing carbon layer. Electric power supplied for generating plasma is not particularly limited, but preferably within a range of 0.1 to 15 W/cm² and more preferably within a range of 0.1 to 13 W/cm². Too small the electric power cannot deposit a hydrogen-containing carbon layer, while too large the electric power might etch the transparent electroconductive oxide layer 2 by excess plasma.

In a case where the transparent electroconductive film is used mainly in a touch panel, an electroluminescence electrode material, a solar cell, or the like, an additional zinc oxide transparent electroconductive oxide layer 5 having a thickness of 20 nm or below can be deposited on a hydrogen-containing carbon layer, as shown in a schematic sectional view in Fig. 5, for the purpose of improvement of electrical contactivity. The contactivity referred to herein means the electric flowability or conductivity at the interface between the transparent electroconductive film and an opposite electrode or a charge-transfer layer. Formation of the thin additional transparent electroconductive oxide layer 5 in this way improves the contactivity of the transparent electroconductive film.

For the additional transparent electroconductive oxide layer 5, doping may be dispensed with so as to give priority to transparency, but doping contributes significantly to the improvement of the contactivity. The doping substance may consist of a compound containing an element such as aluminum, gallium, indium, tin, and boron or a compound containing an element such as phosphorus and nitrogen.

The thinner the additional transparent electroconductive oxide layer 5, the better. The layer 5 is preferably formed at a thickness of 20 nm or below, more preferably at a thickness of 3 to 12 nm, and most preferably at a thickness of 5 to 10 nm. The layer 5 aims to improve the contactivity, so that a sheet resistance of the transparent electroconductive film is necessarily to be controlled by the lower layers, that is, the transparent electroconductive oxide layer 2 and the hydrogen-containing carbon layers 3 and 4.

Specifically, the layer 5 should have the thickness of 20 nm or below that does not affect the sheet resistance of the transparent electroconductive film. Further, the thickness of 20 nm or below also avoids the above-mentioned instability of the zinc oxide layer against humidity and heat.

Further, the layer 5 is formed so as to be inserted in between a plurality of carbon layers as shown in Fig. 5, thereby ensuring the improvement of physical strength like scratch hardness of the transparent electroconductive film.

The sheet resistance of the transparent electroconductive film was measured by a four-probe measurement specified by JIS K7194. The sheet resistance, which depends on characteristics required in a device such as a touch panel, is preferably within a range of 200 to 2000 Ω/Sq. Too large the sheet resistance suggests that the transparent electroconductive oxide layer is too thin, thereby failing to stabilize the sheet resistance of the transparent electroconductive film and readily increasing the sheet resistance especially when left under a high temperature and humidity environment.

In contrast, too small the sheet resistance suggests that the transparent electroconductive oxide layer is too thick, thereby rendering the layer breakable due to its inner stress and causing problems such as lowered transmittance of the layer and cost rise.

The light transmittance for light having a wavelength or 550 nm of the transparent electroconductive film was measured by the integrating sphere light transmittance measurement device specified in JIS K7105. It is an important aspect that the transparent electroconductive film in the present invention satisfies a relationship of T₁/T₀ ≧ 1.02, where T₀ represents a transmittance after deposition of the transparent electroconductive oxide layer 2 on the transparent substrate 1, while T₁ represents a transmittance after covering the resulted layer with the hydrogen-containing carbon layers 3 and 4. Herein, as described above, the transmittances T₀ and T₁ are for light having a wavelength of 550 nm. Shortly, in the present invention, it is found that the control of a composition and a structure of a hydrogen-containing carbon layer shows an effect equaling or surpassing a common low reflecting coating.

### EXAMPLES

Now, various examples are described with some comparative examples below, in response to the above-mentioned embodiments of the present invention.

### (Examples 1 ~ 4, Comparative Examples 1 ~ 2)

A zinc oxide transparent electroconductive oxide layer was deposited on an alkali-free glass substrate (product name: OA-10, made by Nippon Electric Glass Co., Ltd., a thickness of 0.7 mm) by a sputter film-forming method. This film forming was performed using argon as a carrier gas so as to give a film thickness of 500 Å with power of 10 W/cm² under environment of 8 Pa. A carbon layer was deposited on the resulted layer under a total pressure of 100 Pa by a high-frequency plasma CVD method. Flow rates of methane gas and hydrogen gas were changed according to Table 1 respectively. Characteristics of transparent electroconductive films prepared in this way and physical properties of the carbon layers were evaluated.

### (Example 5)

A carbon layer was deposited on an alkali-free glass substrate (product name: OA-10, made by Nippon Electric Glass Co., Ltd., a thickness of 0.7 mm) so that the resulted film had a thickness of 600 Å, under a total pressure of 100 Pa using methane as a material gas by a high-frequency plasma CVD method. Further, a zinc oxide transparent electroconductive oxide layer was deposited on the resulted layer by a sputter film-forming method. This film forming was performed using argon as a carrier gas so as to have a thickness of 500 Å with power of 10 W/cm² under environment of 8 Pa. Characteristics of a transparent electroconductive film prepared in this way and physical properties of the carbon layer were evaluated.

### (Example 6)

A carbon layer was deposited on an alkali-free glass substrate (product name: OA-10, made by Nippon Electric Glass Co., Ltd., a thickness of 0.7 mm) so that the resulted film had a thickness of 600 Å, under a total pressure of 100 Pa using methane as a material gas by a high-frequency plasma CVD method. Further, a zinc oxide transparent electroconductive oxide layer was deposited on the resulted layer by a sputter film-forming method. This film forming was performed using argon as a carrier gas so as to have a thickness of 500 Å with power of 10 W/cm² under environment of 8 Pa. Still further, another carbon layer was deposited on the resulted layer so that the resulted film had a thickness of 600 Å under a total pressure of 100 Pa using methane as a material gas by a high-frequency plasma CVD method. Characteristics of a transparent electroconductive film prepared in this way and physical properties of the carbon layer were evaluated.

### (Examples 7 ~ 8, Comparative Example 3)

A zinc oxide transparent electroconductive oxide layer was deposited on an alkali-free glass substrate (product name: OA-10, made by Nippon Electric Glass Co., Ltd., a thickness of 0.7 mm) by a sputter film-forming method. This film forming was performed using argon as a carrier gas so as to have a film thickness of 500 Å with power of 10 W/cm² under environment of 8 Pa. Further, a carbon layer was deposited on the resulted layer by a magnetron sputtering method.

This film forming was performed using (1) mixture of a first gas selected form argon and hydrogen and a second gas (carbon dioxide) at a flow ratio of 8:2 (Examples 7 and 8), or (2) only hydrogen (Comparative Example 3) so that the resulted film had a thickness of 600 Å under a total pressure of 8.0 Pa with power of 10 W/cm² supplied from a high-frequency power source having 13.56 MHz. Characteristics of transparent electroconductive films prepared in this way and physical properties of the carbon layers were evaluated.

### (Comparative Example 4)

A zinc oxide transparent electroconductive oxide layer was deposited on an alkali-free glass substrate (product name: OA-10, made by Nippon Electric Glass Co., Ltd., a thickness of 0.7 mm) by a sputter film-forming method. This film forming was performed using argon as a carrier gas so as to have a film thickness of 500 Å with power of 10 W/cm² under environment of 8 Pa.

In a transparent electroconductive film prepared in this way, a sheet resistance was 500 Ω/Sq. and a light transmittance for light having a wavelength of 550 nm was 85 %.

When the transparent electroconductive film in the Comparative Example 1 was left for a week at 85 degrees centigrade and at 85 % RH (relative humidity), the sheet resistance significantly increased up to 1680 Ω/Sq. and the light transmittance for light having a wavelength of 550 nm kept 85 %.

That means, in comparison with an Example 9 described below, the transparent electroconductive film in the Comparative Example 4 had no hydrogen-containing carbon covering layer, whereby weatherability (resistance to climatic conditions) relating to the sheet resistance became too low to be enough for practical use.

In the Comparative Examples 1 ~ 3, the sheet resistances rose higher than that of the Comparative Example 4, which means electrical conductivity was reduced. Probably this is because, in the early stage of the film forming, etching of zinc oxide by methane/hydrogen occurs as a competitive reaction of the deposition of the carbon layer.

The results are shown in Table 1 as to film-forming conditions and film thicknesses of carbon layers and electrical and optical characteristics thereof and in Table 2 as to physical properties of the carbon layers. Unit of every particular item in the tables is shown in Table 3. The wavelength dispersion is shown by a calculation expression.

**[Table 1]**

| | Type of gas | Flow rate | Power | Film thickness | Light transmittance | Surface resistance |
|---|---|---|---|---|---|---|
| Example 1 | methane | 50 | 3.0 | 600 | 94 | 450 |
| Example 2 | methane/hydrogen | 37/13 | 3.0 | 600 | 90 | 450 |
| Example 3 | methane/hydrogen | 40/10 | 3.0 | 600 | 92 | 450 |
| Example 4 | methane/hydrogen | 45/5 | 3.0 | 600 | 93 | 450 |
| Example 5 | methane | 50 | 3.0 | 600 | 94 | 450 |
| Example 6 | methane | 50 | 3.0 | 600 | 95 | 450 |
| Example 7 | carbon dioxide /argon | 2/8 | 10.0 | 600 | 96 | 500 |
| Example 8 | carbon dioxide /hydrogen | 2/8 | 2.5 | 600 | 94 | 500 |
| Comparative Example 1 | methane/hydrogen | 25/25 | 3.0 | 400 | 85 | 600 |
| Comparative Example 2 | methane/hydrogen | 10/190 | 3.0 | 400 | 85 | 650 |
| Comparative Example 3 | hydrogen | 10 | 2.5 | 600 | 84 | 600 |
| Comparative Example 4 | - | - | - | - | 85 | 500 |

**[Table 2]**

| | Refractive index | Wavelength dispersion | Film density | Hydrogen content | SP³ bonding ratio |
|---|---|---|---|---|---|
| Example 1 | 1.40 | 0.133 | 0.5 | 11.5 | 62 |
| Example 2 | 1.80 | 0.012 | 1.0 | 13.0 | 65 |
| Example 3 | 1.70 | 0.016 | 0.8 | 12-8 | 65 |
| Example 4 | 1.50 | 0.133 | 0.7 | 12.0 | 63 |
| Example 5 | 1.40 | 0.133 | 0.5 | 11,5 | 62 |
| Example 6 | 1.40 | 0.133 | 0.5 | 11.5 | 62 |
| Example 7 | 1.29 | 0.013 | 0.9 | 0 | 60 |
| Example 8 | 1.65 | 0.019 | 0.6 | 35.0 | 60 |
| Comparative Example 1 | 1.95 | 0.009 | 1.5 | 21.5 | 80 |
| Comparative Example 2 | 2.30 | 0.270 | 2.0 | 21.0 | 83 |
| Comparative Example 3 | 1.86 | 0.050 | 1.8 | 36.0 | 66 |
| Comparative Example 4 | - | - | - | - | - |

**[Table 3]**

| | |
|---|---|
| Item | Unit |
| Flow rate | sccm (standard cubic centimeter per minute) |
| Power | W/cm² |
| Film thickness | Å (angstrom) |
| Light transmittance | % (550 nm) |
| Surface resistance | Ω/Sq. |
| Wavelength dispersion | n_{F} - n_{C} |
| Film density | g/cm³ |
| Hydrogen content | Atom% |
| SP³ bonding ratio | % |

### (Example 9)

A zinc oxide transparent electroconductive oxide layer 2 was deposited on an alkali-free glass substrate (product name: OA-10, made by Nippon Electric Glass Co., Ltd., a thickness of 0.7 mm) by a sputter film-forming method. Specifically, this deposition was performed in a film-forming chamber by using the substrate set at 200 degrees centigrade, introducing argon gas as a carrier gas at a flow rate of 20 sccm, and supplying DC power of 200 W under a pressure of 8 Pa (to be power of 10 W/cm² in the present device), thereby forming the zinc oxide layer 2 having a thickness of 50 nm after deposition for five minutes.

A first hydrogen-containing carbon layer 3 was deposited on the resulted zinc oxide layer 2 by a high-frequency plasma CVD method. Specifically, this deposition was performed in a film-forming chamber by using the substrate set at 200 degrees centigrade, introducing methane gas and hydrogen gas at flow rates of 10 sccm and 200 sccm respectively, and supplying RF power of 200 W under a pressure of 70 Pa (to be power of 10 W/cm² in the present device), thereby forming the first hydrogen-containing carbon layer 3 of a thickness of 5 nm after deposition for 20 minutes. The thus formed layer 3 had a refraction index of 1.90 for light having a wavelength of 550 nm. The refractive index was obtained by fitting a measurement by a spectroscopic ellipsometer VASE made by J. A. Woollam Co., Inc.

A second hydrogen-containing carbon layer 4 containing another composition was deposited on the first hydrogen-containing carbon layer 3 by a high-frequency plasma CVD method. Specifically, this deposition was performed in a film-forming chamber by using the substrate set at 200 degrees centigrade, introducing methane gas at a flow rate of 50 sccm, and supplying RF power of 200 W under a pressure of 70 Pa (to be power of 10 W/cm² in the present device), thereby forming the second hydrogen-containing carbon layer 4 of a thickness of 80 nm after deposition for 20 minutes. The thus formed layer 4 had a refraction index of 1.55 for light having a wavelength of 550 nm.

In the transparent electroconductive film prepared in this way of the Example 9, a sheet resistance was 290 Ω/Sq. and a light transmittance for light having a wavelength or 550 nm was 90 %. It is obvious that the sheet resistance in this Example 9 was lower than that of only the zinc oxide transparent electroconductive oxide layer (Comparative Example 4) and than that of Example 1, which means electrical conductivity was improved. Probably this is due to hydrogen passivation effect in depositing of the carbon layer.

The transparent electroconductive film satisfied the following expression: T₁/T₀ = 1.07. That means the light transmittance was significantly improved by covering the zinc oxide layer 2 with the hydrogen-containing layers 3 and 4.

Further, when the transparent electroconductive film in the Example 9 was left for a week at 85 degrees centigrade and at 85 % RH (relative humidity), the sheet resistance, slightly increased to 300 Ω/Sq., but the light transmittance for light having a wavelength or 550 nm kept 90 %. That means, as seen from the comparison with the above-mentioned Comparative Example 4, weatherability relating to the sheet resistance of the transparent electrode film is significantly improved by covering the zinc oxide layer 2 with the hydrogen-containing layers 3 and 4.

### (Example 10)

Example 10 in this invention was firstly prepared in the same manner as the Example 9, by sequential deposition of a zinc oxide layer 2, a first hydrogen-containing carbon layer 3, and a second hydrogen-containing carbon layer 4 on an alkali-free glass substrate 1.

Furthermore, a hydrogen-containing carbon layer (not shown) to be a third layer was deposited on the second hydrogen-containing carbon layer 4 by a high-frequency plasma CVD method. The carbon layer of the third layer was formed by the same depositing conditions as the first hydrogen-containing carbon layer of the first layer, having the same thickness, structure, composition and refractive index.

In a transparent electroconductive film prepared in this way of the Example 10, a sheet resistance was 320 Ω/Sq. and a light transmittance for light having a wavelength of 550 nm was 86 %. The transparent electroconductive film satisfied the following expression: T₁/T₀= 1.02.

Further, when the transparent electroconductive film in the Example 10 was left for a week at 85 degrees centigrade and at 85 % RH (relative humidity), the sheet resistance kept 320 Ω/Sq. and the light transmittance for light having a wavelength of 550 nm kept 86 %.

In comparison with the Example 9, in the transparent electroconductive film in the Example 10, it is found that the sheet resistance slightly rose and the light transmittance was slightly lowered because of the additional hydrogen-containing carbon layer, but weatherability relating to the sheet resistance was slightly improved. In the transparent electrode film formed by the present invention, it is obvious that three or more hydrogen-containing carbon covering layers may be included if desired.

### (Example 11)

A transparent electroconductive layer in Example 11 was formed in the same manner as the Example 9 except only that hydrogen-containing carbon layers were deposited in the inverse order.

In the transparent electroconductive layer in the Example 11 prepared in this way, a sheet resistance was 290 Ω/Sq. and a light transmittance for light having a wavelength of 550 nm was 88 %. The transparent electroconductive film satisfied the following expression: T₁/T₀ = 1.03.

Further, when the transparent electroconductive film in the Example 11 was left for a week at 85 degrees centigrade and at 85 % RH (relative humidity), the sheet resistance slightly increased to 300 Ω/Sq. and the light transmittance for light having a wavelength of 550 nm kept 88 %.

It is revealed, from comparison between the Example 11 and the Example 9, that hydrogen-containing carbon layers produce a substantially same effect regardless of a depositing order of the layers.

### (Example 12)

Example 12 corresponds to Fig. 5 and was formed in the same manner as the Example 9 except only that an additional zinc oxide layer 5 was deposited on the hydrogen-containing carbon layer 4.

This depositing of the additional zinc oxide layer 5 was performed under the same condition as the zinc oxide transparent electroconductive oxide layer 2 except that the depositing time was shortened to one minute and the deposited thickness was reduced to 10 nm.

In a transparent electroconductive film in the Example 12 prepared in this way, a sheet resistance was 290 Ω/Sq. and a light transmittance for light having a wavelength of 550 nm was 90 %. The transparent electroconductive film satisfied the following expression: T₁/T₀ = 1.03.

Further, when the transparent electroconductive film in the Example 12 was left for a week at 85 degrees centigrade and at 85 % RH (relative humidity), the sheet resistance slightly increased to 300 Ω/Sq. and the light transmittance for light having a wavelength of 550 nm kept 90 %.

It is revealed, from comparison between the Example 12 and the Example 9, that deposition of an additional extremely-thin zinc oxide layer having a thickness of 10 nm or below on a hydrogen-containing carbon covering layer has no harmful effects on characteristics and weatherability of the resulted transparent electrode film.

### INDUSTRIAL APPLICABILITY

As described above, the present invention can provide an improved transparent electroconductive film achieving simultaneously a high resistance to environmental variation and a high light transmittance and a method for producing the same.

## Claims

1. A method for producing a transparent electroconductive film comprising the steps of providing at least one transparent electroconductive oxide layer and depositing a carbon layer on at least one surface of the at least one transparent electroconductive oxide layer,
wherein the carbon layer is formed by a high frequency plasma CVD method using at least one gas selected from a group consisting of methane, carbon dioxide, and hydrogen and satisfies at least one of below-identified expressions (1) to (3) relating to gas volumes V (methane), V(carbon dioxide), and V (hydrogen):
(1) 0.7 ≦ V (methane)/(V (methane) + V (hydrogen)) ≦ 1.0
(2) 0.6 ≦ V (methane)/(V (methane) + V (carbon dioxide)) ≦ 1.0
(3) 0.04 ≦ V (carbon dioxide)/(V (hydrogen) + V (carbon dioxide))
≦ 0.10.

2. A method for producing a transparent electroconductive film comprising the steps of providing at least one transparent electroconductive oxide layer and depositing a carbon layer on at least one surface of the at least one transparent electroconductive oxide layer,
wherein the carbon layer is formed by a magnetron sputtering method targeting carbon and using at least two gases selected from a group consisting of carbon dioxide, hydrogen, and argon and satisfies at least one of below-identified expressions (4) and (5) relating to gas volumes V (carbon dioxide), V(hydrogen), and V (argon):
(4) 0.10 ≦ V (carbon dioxide)/(V (carbon dioxide) + V (hydrogen)
≦ 0.30
(5) 0.10 ≦ V (carbon dioxide)/(V (carbon dioxide) + V (argon))≦ 0.30.

3. A transparent electroconductive film prepared by the method as defined in claim 1 or 2,
wherein the carbon layer has a refractive index within a range of 1.25 to 1.85 at a wavelength of 550 nm and further has a value of a below-identified expression (6) within a range of 0.01 to 0.20, where n_{F} and n_{C} represent refractive indexes at wavelengths of 486.1 nm and 656.3 nm respectively.
(6) [average dispersion] = n_{F} - n_{C}

4. The transparent electroconductive film as defined in claim 3,
wherein the carbon layer has a density of 0.3 to 1.3 g/cm³.

5. The transparent electroconductive film as defined in claim 3 or 4,
wherein the carbon layer has a hydrogen content at 36.0 atom % or below in its structure.

6. The transparent electroconductive film as defined in one of claims 3 to 5,
wherein the carbon layer has an SP³ bonding ratio at 55 % or more, the ratio being measured by X-ray photoelectron spectroscopy.

7. A transparent electroconductive film comprising:
a transparent substrate;
at least one transparent electroconductive oxide layer deposited on the transparent substrate; and
a plurality of hydrogen-containing carbon layers deposited on the transparent electroconductive oxide layer,
wherein at least one layer of the transparent electroconductive oxide layer contains zinc oxide, and
wherein at least two layers of the hydrogen-containing carbon layers are different from each other in at least one of their configurations and their compositions,
the transparent electroconductive film satisfying a relationship of T₁/T₀
≧ 1.02 for light having a wavelength of 550 nm where T₀ represents a light transmittance of the transparent substrate on which the at least one transparent electroconductive oxide layer is deposited and T₁ represents a light transmittance of the transparent substrate on which the at least one transparent electroconductive oxide layer and the plurality of hydrogen-containing carbon layers are deposited.

8. The transparent electroconductive film as defined in claim 7,
wherein at least one of the plurality of hydrogen-containing carbon layers has a refractive index within a range of 1.40 to 1.70 for light having a wavelength of 550 nm,

9. The transparent electroconductive films as defined in one of claims 1, 2 and 7,
further comprising a transparent electroconductive oxide layer having a thickness of 20 nm and containing zinc oxide, the layer being deposited on one of the hydrogen-containing carbon layers.

10. A method for producing the transparent electroconductive film as defined in one of claims 7 to 9,
wherein each of the hydrogen-containing carbon layers is formed by a high frequency plasma CVD method using one of methane gas and a gas mixture of methane and hydrogen as a material gas.
